# EUROPEAN PATENT APPLICATION

(11) **EP 3 139 386 A1**
(43) Date of publication of application: **08.03.2017**
(21) Application number: 16182349.7
(22) Date of filing: 02.08.2016
(51) Int. Cl.: G11C 16/14, G11C 16/34

(54) **SEMICONDUCTOR MEMORY DEVICE AND MEMORY SYSTEM**

(30) Priority: 07.09.2015 JP 2015175763
(71) Applicant: Kabushiki Kaisha Toshiba, Minato-ku, Tokyo (JP)
(72) Inventor: Kodama, Erika, Tokyo (JP); Iwai, Hitoshi, Tokyo (JP)
(74) Representative: Hoffmann Eitle

(57) **Abstract**

A semiconductor memory device includes a memory cell transistor and a word line connected a gate of the memory cell transistor. A first erase voltage is applied to the memory cell transistor when an erasing operation of a first type is performed on the memory cell transistor, and a second erase voltage, lower than the first erase voltage, is applied to the memory cell transistor when an erasing operation of a second type is performed on the memory cell transistor.

## Description

### CROSS-REFERENCE TO RELATED APPLICATION

This application is based upon and claims the benefit of priority from Japanese Patent Application No. 2015-175763, filed September 7, 2015, the entire contents of which are incorporated herein by reference.

### FIELD

Embodiments described herein relate generally to a semiconductor memory device and to a memory system.

### BACKGROUND

A NAND flash memory is known as one type of a semiconductor memory device.

### DESCRIPTION OF THE DRAWINGS

FIG. 1 is a block diagram of a memory system according to a first embodiment.
FIG. 2 is a block diagram of a semiconductor memory device according to the first embodiment.
FIG. 3 is a timing chart of various signals during a normal erase mode in the memory system according to the first embodiment.
FIG. 4 is a timing chart of various signals during a slow erase mode in the memory system according to the first embodiment.
FIG. 5 is a flowchart illustrating an erasing operation in the semiconductor memory device according to the first embodiment.
FIG. 6 is a timing chart illustrating a voltage of each wiring when an erase pulse is applied in the semiconductor memory device according to the first embodiment.
FIG. 7 is a graph illustrating a relationship between the number of erase loops and an erase pulse during an erasing operation in a semiconductor memory device according to a second embodiment.
FIG. 8 is a timing chart of various signals during a normal program mode in a memory system according to a third embodiment.
FIG. 9 is a timing chart of various signals during a slow program mode in the memory system according to the third embodiment.
FIG. 10 is a flowchart illustrating a writing operation in a semiconductor memory device according to the third embodiment.
FIG. 11 is a timing chart illustrating a voltage of each wiring during the normal program mode in the semiconductor memory device according to the third embodiment.
FIG. 12 is a timing chart illustrating a voltage of each wiring during the slow program mode in the semiconductor memory device according to the third embodiment.
FIG. 13 is a graph illustrating a relationship between the number of program loops and a program pulse during a writing operation in a semiconductor memory device according to a fourth embodiment.
FIG. 14 is a flowchart illustrating an operation of a memory system according to a first example of a fifth embodiment when erasing is suspended.
FIG. 15 is a timing chart illustrating a relationship between signal communication and an erasing operation when erasing is suspended in the memory system according to the first example of the fifth embodiment.
FIG. 16 is a timing chart illustrating a relationship between signal communication and an erasing operation when erasing is suspended in a memory system according to a second example of the fifth embodiment.
FIG. 17 is a diagram illustrating a state of a page during a dummy data writing operation in a semiconductor memory device according to a sixth embodiment.
FIG. 18 is a timing chart illustrating a relationship between signal communication and a writing operation during the dummy data writing operation in a memory system according to the sixth embodiment.
FIG. 19 is a flowchart illustrating an operation of a controller during an erasing operation in a memory system according to a first example of a seventh embodiment.
FIG. 20 is a flowchart illustrating an operation of a controller during a writing operation in a memory system according to a second example of the seventh embodiment.

### DETAILED DESCRIPTION

Embodiments provide a semiconductor memory device and a memory system capable of suppressing degradation of a memory cell transistor.

In general, according to one embodiment, a semiconductor memory device includes a memory cell transistor and a word line that is connected to a gate of the memory cell transistor. A first erase pulse is applied to the memory cell transistor when an erasing operation of a first type is performed on the memory cell transistor, and a second erase voltage, lower than the first erase voltage, is applied to the memory cell transistor when an erasing operation of a second type is performed on the memory cell transistor.

Hereinafter, embodiments will be described with reference to the drawings. In this description, common elements in all of the drawings will be designated by a common reference sign.

### 1. First Embodiment

A semiconductor memory device and a memory system according to a first embodiment will be described. Hereinafter, the semiconductor memory device will be exemplified by a planar NAND flash memory in which memory cell transistors are two-dimensionally arranged on a semiconductor substrate.

### 1. 1. Configuration

### 1. 1. 1 Entire Configuration of Memory System

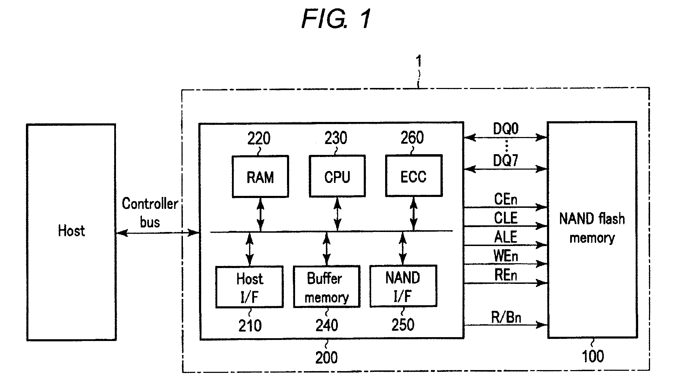

First, an entire configuration of the memory system according to the present embodiment will be described with reference to FIG. 1.

As illustrated in FIG. 1, a memory system 1 includes a NAND flash memory 100 and a controller 200. The controller 200 and the NAND flash memory 100, for example, may be combined to make up one semiconductor memory device that is exemplified by a memory card such as an SDTM card or by a solid state drive (SSD).

The NAND flash memory 100 includes multiple memory cell transistors and stores data in a nonvolatile manner. The NAND flash memory 100 is connected to the controller 200 by a NAND bus and is operated based on a command from the controller 200. That is, the NAND flash memory 100 communicates, for example, an 8-bit input-output signal I/O with the controller 200 through data lines DQ0 to DQ7. The input-output signal I/O includes, for example, data, an address signal, and a command signal. The NAND flash memory 100 receives, for example, a chip enable signal CEn, a command latch enable signal CLE, an address latch enable signal ALE, a write enable signal WEn, and a read enable signal REn from the controller 200. The NAND flash memory 100 transmits a ready/busy signal R/Bn to the controller 200.

The chip enable signal CEn is used to enable the NAND flash memory 100 and is asserted at a low level. The command latch enable signal CLE indicates that the input-output signal I/O contains a command and is asserted at a high level. The address latch enable signal ALE indicates that the input-output signal I/O contains an address and is asserted at the high level. The write enable signal WEn is used to write a received signal into the NAND flash memory 100 and is asserted at the low level each time a command, an address, data, and the like are received from the controller 200. Accordingly, a signal is written into the NAND flash memory 100 each time the write enable signal WEn is toggled. The read enable signal REn is used for the controller 200 to read each data from the NAND flash memory 100. For example, the read enable signal REn is asserted at the low level. The ready/busy signal R/Bn indicates whether or not the NAND flash memory 100 is in a busy state (whether the NAND flash memory 100 can receive a command from the controller 200 or not) and is set at the low level in the busy state.

The controller 200 commands the NAND flash memory 100 to, for example, read, write, or erase data in response to a command from a host device. In addition, the controller 200 manages a memory space of the NAND flash memory 100.

The controller 200 includes a host interface circuit 210, an internal memory (RAM) 220, a processor (CPU) 230, a buffer memory 240, a NAND interface circuit 250, and an ECC circuit 260.

The host interface circuit 210 is connected to the host device through a controller bus and communicates with the host device. The host interface circuit 210 transfers a command and data received from the host device respectively to the processor 230 and to the buffer memory 240. In addition, the host interface circuit 210 transfers data in the buffer memory 240 to the host device in response to a command of the processor 230.

The NAND interface circuit 250 is connected to the NAND flash memory 100 through a NAND bus and communicates with the NAND flash memory 100. The NAND interface circuit 250 transfers a command received from the processor 230 to the NAND flash memory 100 and, when performing writing, transfers data written into the buffer memory 240 to the NAND flash memory 100. Furthermore, when performing reading, the NAND interface circuit 250 transfers data read from the NAND flash memory 100 to the buffer memory 240.

The processor 230 controls operation of the entire controller 200. For example, the processor 230, when receiving a write command from the host device, outputs the write command to the NAND flash memory 100 in response thereto. The same applies to also reading and erasing. In addition, the processor 230 performs various processes such as wear leveling to manage the NAND flash memory 100. Furthermore, the processor 230 performs various calculations. For example, the processor 230 encrypts or randomizes data.

The ECC circuit 260 performs data error checking and correcting (ECC).

The internal memory 220 is a semiconductor memory such as a DRAM and is used as a work area of the processor 230. The internal memory 220 stores firmware, various management tables, and the like to manage the NAND flash memory 100.

### 1. 1. 2 Entire Configuration of Semiconductor Memory Device

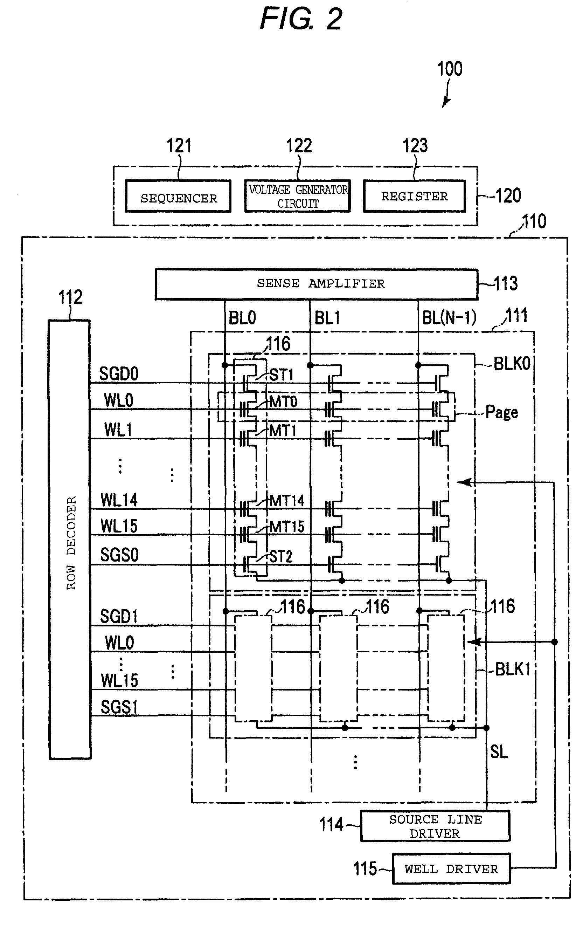

Next, an entire configuration of the semiconductor memory device will be described with reference to FIG. 2. As illustrated in FIG. 2, the NAND flash memory 100 schematically includes a core portion 110 and a peripheral circuit portion 120.

The core portion 110 includes a memory cell array 111, a row decoder 112, a sense amplifier 113, a source line driver 114, and a well driver 115.

The memory cell array 111 includes multiple blocks BLK (BLK0, BLK1, ...), each including a set of multiple nonvolatile memory cell transistors. In one embodiment, data in one block BLK is erased at the same time.

Each block BLK includes multiple NAND strings 116, each of which is a serial connection of memory cell transistors. Each NAND string 116, for example, includes 16 memory cell transistors MT (MT0 to MT15) and select transistors ST1 and ST2. Each memory cell transistor MT includes a control gate and a charge storage layer and stores data in a nonvolatile manner. Each memory cell transistor MT may be an MONOS type in which an insulating film is used as the charge storage layer or may be an FG type in which a conductive film is used as the charge storage layer. Furthermore, the number of memory cell transistors MT is not limited to 16. The number may be, for example, 8, 32, 64, or 128 and is not limited to a particular number.

The memory cell transistors MT0 to MT15 have current paths that are connected in series. A drain of the memory cell transistor MT0 at one end of this serial connection is connected to a source of the select transistor ST1, and a source of the memory cell transistor MT15 at the other end thereof is connected to a drain of the select transistor ST2.

Gates of the select transistors ST1 in one block BLK are connected in common to one select gate line SGD. In the example of FIG. 2, gates of the select transistors ST1 in the block BLK0 are connected in common to a select gate line SGD0, and gates of the select transistors ST1 in the block BLK1, not illustrated, are connected in common to a select gate line SGD1. Similarly, gates of the select transistors ST2 in one block BLK are connected in common to one select gate line SGS.

The control gates of the memory cell transistors MT of each NAND string 116 in the block BLK are respectively and in common connected to different word lines WL0 to WL15.

Drains of the select transistors ST1 of the NAND strings 116 in one column, among the NAND strings 116 arranged in a matrix configuration in the memory cell array 111, are connected in common to one of bit lines BL (BL0 to BL(N-1), where (N-1) is a natural number greater than or equal to one). That is, the bit lines BL connect the NAND strings 116 in common between the multiple blocks BLK. Sources of the select transistors ST2 in each block BLK are connected in common to a source line SL. That is, the source line SL, for example, connects the NAND strings 116 in common between the multiple blocks BLK.

The row decoder 112 decodes the address of the block BLK or the address of a page when, for example, writing and reading data and selects a word line that corresponds to a target page. Then, the row decoder 112 applies appropriate voltages to the selected word line WL and the non-selected word lines WL of the selected block BLK and to the select gate lines SGD and SGS.

The sense amplifier 113, when reading data, senses data that is read into the bit lines from the memory cell transistors. When writing data, the sense amplifier 113 transfers data to be written to the memory cell transistors MT through the bit lines.

The source line driver 114 applies a voltage to the source line SL.

The well driver 115 applies a voltage to a p-well region where the NAND strings 116 are formed (that is, to back gates of the memory cell transistors MT).

The peripheral circuit portion 120 includes a sequencer 121, a voltage generator circuit 122, and a register 123.

The sequencer 121 controls operation of the entire NAND flash memory 100.

The voltage generator circuit 122 generates voltages necessary for writing, reading, and erasing data and supplies the voltages to the row decoder 112, the sense amplifier 113, the source line driver 114, the well driver 115, and the like.

The register 123 stores various signals. For example, the register 123 stores the status of a data writing operation or a data erasing operation and notifies the controller 200 of whether or not the operation is normally completed based on the status. Alternatively, the register 123 can store various tables.

While the memory cell transistors MT are described as being two-dimensionally arranged on a semiconductor substrate in the present example, the memory cell transistors MT may be three-dimensionally stacked on a semiconductor substrate.

A configuration of the memory cell array 111 in a three-dimensionally stacked NAND flash memory, for example, is disclosed in U.S. Patent Application No. 12/407,403, entitled "THREE DIMENSIONAL STACKED NONVOLATILE SEMICONDUCTOR MEMORY." filed March 19, 2009, in U.S. Patent Application No. 12/406,524, entitled "THREE DIMENSIONAL STACKED NONVOLATILE SEMICONDUCTOR MEMORY," filed March 18, 2009, in U.S. Patent Application No. 12/679,991, entitled "NONVOLATILE SEMICONDUCTOR STORAGE DEVICE AND METHOD OF MANUFACTURING THE SAME," filed March 25, 2010, and in U.S. Patent Application No. 12/532,030, entitled "SEMICONDUCTOR MEMORY AND METHOD OF MANUFACTURING THE SAME," filed March 23, 2009. The entire contents of these patent applications are incorporated in the present specification by reference.

The size of data to be erased is not limited to one block BLK. Multiple blocks BLK may be erased at the same time, or only a portion of the area of one block BLK may be erased at the same time.

Erasure of data, for example, is disclosed in U. S. Patent Application No. 12/694,690, entitled "NONVOLATILE SEMICONDUCTOR STORAGE DEVICE," filed January 27, 2010. In addition, erasure of data is disclosed in U.S. Patent Application No. 13/235,389, entitled "NONVOLATILE SEMICONDUCTOR MEMORY DEVICE," filed September 18, 2011. The entire contents of these patent applications are incorporated in the present specification by reference.

### 1. 2 Data Erasing operation

Next, a data erasing operation according to the present embodiment will be described. An erasing operation includes an operation that applies an erase pulse to decrease (to shift in a negative voltage direction) a threshold voltage of the memory cell transistor MT and includes erase verification that determines whether or not the threshold voltage of the memory cell transistor MT, as a result of the application of the erase pulse, is smaller than a target value. There are two erase modes referred to as "normal erase mode" and "slow erase mode" in the erasing operation. The NAND flash memory 100 performs the erasing operation in any one erase mode based on a command received from the controller 200. The normal erase mode and the slow erase mode have different conditions for the erase pulse. Specifically, the level and time of voltage application to the back gate of the memory cell transistor MT are different in these modes. The potential of the erase pulse is smaller in the slow erase mode than is in the normal erase mode, and the period of application of the erase pulse is longer in the slow erase mode than is in the normal erase mode. Hereinafter, details of the erasing operation will be described.

### 1. 2. 1 Operation of Controller 200

First, operation of the controller 200 during the erasing operation will be described.

### 1. 2. 1. 1 In Normal Erase Mode

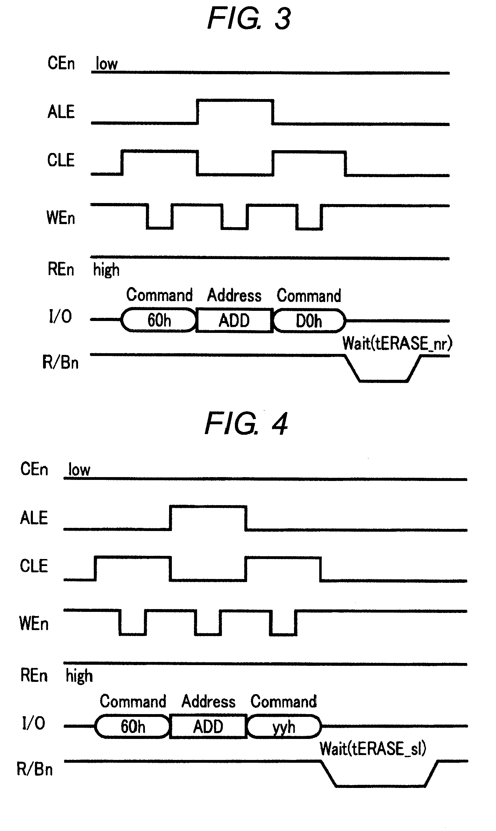

First, operation of the controller 200 in the normal erase mode will be described with reference to FIG. 3.

As illustrated in FIG. 3, the processor 230, first, outputs a command "60h" to the NAND flash memory 100 and asserts the command latch enable signal CLE (at an "H" level). The command "60h" instructs the NAND flash memory 100 to perform the erasing operation.

Next, the processor 230 outputs address data "ADD" and asserts the address latch enable signal ALE (at the "H" level) . While the address data has one cycle in the example of FIG. 3, the address data may have multiple cycles to transmit a column address, a row address, and the like. The row address may include a block address and a page address. Furthermore, the page address, for example, may include information that is related to the word lines WL, even/odd bit lines (E/O), a string address, or a lower/middle/upper page (L/M/U).

An example configuration of the page address is disclosed in U.S. Patent Application No. 13/784,753, entitled "NONVOLATILE SEMICONDUCTOR MEMORY DEVICE AND CONTROL METHOD THEREOF," filed March 4, 2013. The entire contents of this patent application is incorporated in the present specification by reference.

The processor 230 outputs a normal erase command "D0h" and asserts the command latch enable signal CLE.

These commands and addresses, for example, are stored in the register 123 of the NAND flash memory 100 each time the write enable signal WEn is toggled.

The NAND flash memory 100, in response to the command "D0h", initiates the erasing operation in the normal erase mode and transitions into the busy state (R/Bn = "L"). Hereinafter, the period of the busy state, that is, the period of the erasing operation in the normal erase mode, will be designated by a reference sign tERASE_nr.

The NAND flash memory 100 transitions into a ready state when the erasing operation is completed, and the ready/busy signal R/Bn returns to the "H" level.

### 1. 2. 1. 2 In Slow Erase Mode

Next, operation of the controller 200 in the slow erase mode will be described with reference to FIG. 4. Hereinafter, only different points from the normal erase mode will be described.

As illustrated in FIG. 4, the processor 230, after outputting the address, outputs a slow erase command "yyh" and asserts the command latch enable signal CLE. Then, the NAND flash memory 100, in response to the command "yyh", initiates the erasing operation in the slow erase mode and transitions into the busy state (R/Bn = "L"). If the period of the busy state at this time is tERASE_sl, a relationship tERASE_sl > tERASE_nr is satisfied if the number of erase loops is the same in both modes.

### 1. 2. 2 Operation of NAND Flash Memory 100

Next, operation of the NAND flash memory 100 during the erasing operation will be described.

### 1. 2. 2. 1 Overall Flow of Erasing operation

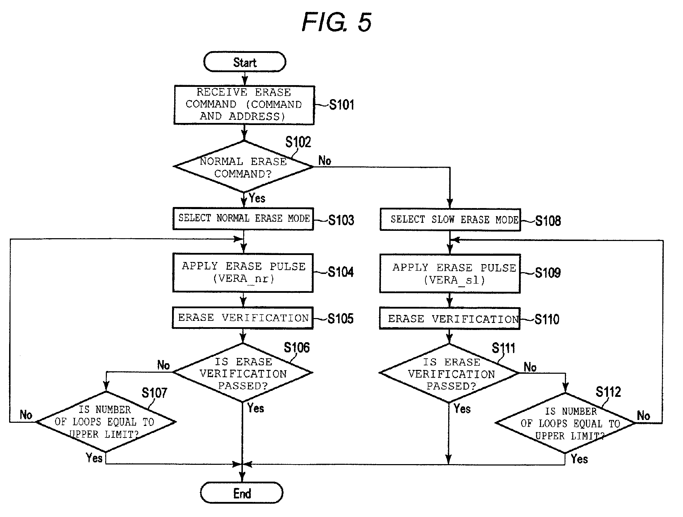

First, an overall flow of the erasing operation will be described with reference to FIG. 5.

As illustrated in FIG. 5, first, the sequencer 121 receives an erase command (erase command and address) from the controller 200 (Step S101).

The sequencer 121 selects the normal erase mode (Step S103) if the sequencer 121 receives the normal erase command "D0h" from the controller 200 (Yes in Step S102).

The sequencer 121 initiates the erasing operation in response to the received command "D0h" and, first, applies the erase pulse. More specifically, the well driver 115 applies the erase pulse to the p-well region formed in the memory cell transistors according to a command of the sequencer 121 (Step S104).

Next, the sequencer 121 performs the erase verification (Step S105). Hereinafter, a state where data of the memory cell transistors MT is determined to be erased will be referred to as "erase verification is passed", and a state where erasure of the data is determined to be not completed will be referred to as "erase verification is failed".

The erasing operation ends if the erase verification is passed (Yes in Step S106). Alternatively, if the erase verification is failed (No in Step S106), the sequencer 121 determines whether or not the number of erase loops is equal to a preset upper limit number (Step S107). Hereinafter, a repetition of application of the erase pulse and the erase verification will be referred to as "erase loop". The sequencer 121 repeats application of the erase pulse and the erase verification until either the erase verification is passed or the number of erase loops reaches the upper limit number.

The sequencer 121, if the number of erase loops reaches the upper limit number (Yes in Step S107), ends the erasing operation and reports to the controller 200 that the erasing operation is not normally ended.

The sequencer 121, if the number of erase loops does not reach the upper limit number (No in Step S107), returns to Step S104 and again applies the erase pulse. That is, the well driver 115 applies the erase pulse to the p-well region.

The sequencer 121 selects the slow erase mode (Step S108) if the sequencer 121 receives the slow erase command "yyh" from the controller 200 (No in Step S102).

The sequencer 121 applies the erase pulse in response to the received command "yyh" (Step S109).

Next, the sequencer 121, in the same manner as in the normal erase mode, performs the erase verification (Step S110) and repeats the erase loop until either the erase verification is passed (Yes in Step S111) or the number of erase loops reaches the preset upper limit number (Yes in Step S112).

### 1. 2. 2. 2 Voltage in Application of Erase Pulse

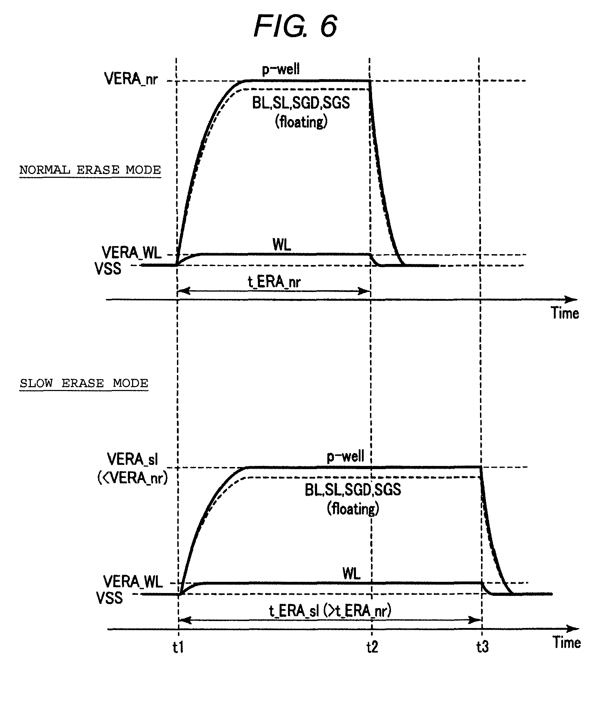

Next, a relationship in potential between each wiring when the erase pulse is applied will be described with reference to FIG. 6. The graph at the upper portion of FIG. 6 illustrates the relationship when the normal erase mode is selected, and the graph at the lower portion of FIG. 6 illustrates the relationship when the slow erase mode is selected.

First, the relationship in the normal erase mode will be described. As illustrated at the upper portion of FIG. 6, the well driver 115 applies a voltage VERA_nr, as the erase pulse, to the p-well region of the selected block BLK at a time t1.

The row decoder 112 applies a voltage VERA_WL to the word lines WL of the erasure target block BLK. The voltage VERA_WL is sufficiently smaller than the voltage VERA_nr to pull electrons out of the charge storage layer. The potential difference between the voltage VERA_nr and the voltage VERA_WL causes electrons to be pulled out of the charge storage layers of the memory cell transistors MT that are connected to the selected word lines WL, and data is erased. While the bit lines BL, the source line SL, and the select gate lines SGD and SGS are described as being in a floating state in FIG. 6, the row decoder 112 may apply the voltage VERA_nr to the select gate lines SGD and SGS.

Next, recovery is performed after a time t2, and application of the erase pulse ends. Hereinafter, the period during which the erase pulse is applied once (during the times t1 and t2) in the normal erase mode will be referred to as "period t_ERA_nr".

Next, the relationship in the slow erase mode will be described. Hereinafter, only different points from the normal erase mode will be described.

As illustrated at the lower portion of FIG. 6, the well driver 115 applies a voltage VERA_sl, as the erase pulse, to the p-well region at the time t1. The voltage VERA_sl is smaller than the voltage VERA_nr. The row decoder 112 applies the voltage VERA_WL to the word lines WL. Accordingly, the potential difference between the word lines WL and the p-well region (back gates) is smaller in the slow erase mode than is in the normal erase mode. Hereinafter, the voltage VERA_nr and the voltage VERA_sl will be simply referred to as a voltage VERA unless otherwise specifically distinguished.

A relationship t_ERA_sl > t_ERA_nr is satisfied if the period during which the erase pulse is applied once (during the times t1 to t3) in the slow erase mode is "period t_ERA_sl". That is, the erase pulse is set to have a smaller potential and to be applied for a longer period in the slow erase mode than is in the normal erase mode.

Next, recovery is performed after the time t3, and application of the erase pulse ends.

### 1. 3 Effect of Present Embodiment

Structures of the memory cell transistors MT used in a nonvolatile semiconductor memory device, such as a NAND flash memory, include an FG structure, an MONOS structure, and the like. However, repeated writing (writing and erasing) of data in any one of the structures changes (degrades) writing and erasing characteristics because of degradation and the like of gate insulating films of the memory cell transistors MT. A significant change in the characteristics may prevent write and erasing operations from being normally performed. Therefore, the number of data rewrites is required to be restricted in the memory cell transistors MT.

Regarding this point, for example, decreasing the voltage of the erase pulse (voltage VERA) during the erasing operation can suppress degradation of the memory cell transistors MT, thereby improving endurance to degradation from rewriting (hereinafter, referred to as "write/erase endurance (W/E endurance)"). However, in order to decrease the threshold voltage sufficiently, the period of application of the erase pulse is required to be increased by an amount corresponding to the amount of the voltage decreased. If the period of application of the erase pulse increases, erasing time (processing time from initiation of the erasing operation until completion thereof) tends to increase, and in turn, a delay may occur in a subsequent operation. In addition, the erasing operation is required to be completed in a certain amount of time if, for example, the erasing time is constrained based on the purpose of use. Therefore, a complication exists in extending the period of application of the erase pulse.

Accordingly, generally in products before shipment, the voltage of the erase pulse and the period of application of the erase pulse are set based on the assumption of a trade-off relationship between the two, such that the erasing time transitions within an allowable range for the user.

Regarding this point, in the configuration according to the present embodiment, the semiconductor memory device has two erase modes including the normal erase mode and the slow erase mode. In addition, the controller 200, for example, can select either the normal erase mode or the slow erase mode according to whether or not the erasing time is constrained. Accordingly, the semiconductor memory device can have improved write/erase endurance with almost no decrease in a processing capability thereof. Hereinafter, this effect will be specifically described.

The controller 200 selects the slow erase mode if the erasing time is not constrained, for example, if a subsequent command is not received yet from the host device. Accordingly, the semiconductor memory device decreases the voltage of the erase pulse applied to the memory cell transistors MT and, thus, can suppress degradation of the memory cell transistors MT. That is, the semiconductor memory device can perform the erasing operation with priority given to improving the write/erase endurance. In this case, while the erasing time tends to be longer than is in the normal erase mode, there is no decrease in the processing capability with respect to the host device, that is, in the processing speed, because a subsequent command is not received yet from the host device.

Alternatively, the controller 200 selects the normal erase mode if the erasing time is constrained. Accordingly, the semiconductor memory device can perform the erasing operation by giving priority to the erasing time (processing capability).

Accordingly, in the configuration according to the present embodiment, selecting an erase mode depending on the situation suppresses degradation of the memory cell transistors MT with almost no decrease in the processing capability with respect to a request from the host device, thereby leading to an improvement in the write/erase endurance. In addition, an improvement in the write/erase endurance can increase the upper limit of the number of data rewrites.

Furthermore, the capability to suppress degradation of the memory cell transistors MT can suppress erroneous writing/erasing, thereby improving reliability.

In addition, in the configuration according to the present embodiment, since the potential of the erase pulse is smaller in the slow erase mode, the charging capacity of the bit lines BL, the source line SL, and the select gate lines SGD and SGS is reduced in comparison with the normal erase mode. Accordingly, power consumption can be reduced.

A three-dimensional stacked NAND flash memory includes the blocks BLK having a large memory size in comparison with relative to a two-dimensional NAND flash memory, and thus, the erasing time tends to increase. Accordingly, the voltage VERA tends to have a high potential and a short period of application in the three-dimensional stacked NAND flash memory in comparison with the two-dimensional NAND flash memory. Accordingly, the three-dimensional NAND flash memory can be said to have a configuration in which memory cell transistors are likely to be degraded more by the erasing operation in comparison with the two-dimensional NAND flash memory. Therefore, the present embodiment results in a more desirable effect if applied to the three-dimensional NAND flash memory.

### 2. Second Embodiment

Next, a semiconductor memory device and a memory system according to a second embodiment will be described. The present embodiment relates to a step-up amount in the erasing operation of the first embodiment when stepping the erase pulse up according to the number of erase loops. Hereinafter, only different points from the first embodiment will be described.

### 2. 1 Relationship between Number of Erase Loops and Erase Pulse

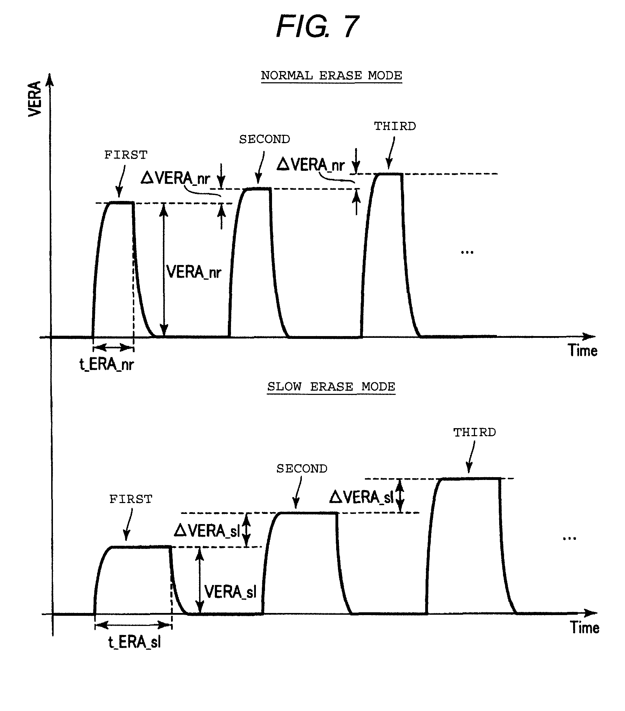

A relationship between the number of erase loops and the erase pulse (voltage VERA) will be described with reference to FIG. 7. The upper portion of FIG. 7 illustrates a relationship between the number of erase loops and the voltage VERA_nr in the normal erase mode, and the lower portion of FIG. 7 illustrates a relationship between the number of erase loops and the voltage VERA_sl in the slow erase mode.

As illustrated at the upper portion of FIG. 7, the potential of the erase pulse is stepped up by ΔVERA_nr in the normal erase mode each time the erase loop is repeated. In contrast, as illustrated at the lower portion of FIG. 7, the potential of the erase pulse in the slow erase mode is stepped up by ΔVERA_sl that is greater than ΔVERA_nr in the normal erase mode.

### 2. 2 Effect of Present Embodiment

In the configuration according to the present embodiment, the amount of the erase pulse stepped up is greater in the slow erase mode than is in the normal erase mode. Accordingly, when the slow erase mode is selected, the number of erase loops (number of times the erase pulse is applied) can be decreased while increasing a change in the threshold voltage resulting from applying the erase pulse once. Accordingly, the amount of delay in the erasing time resulting from an increased period of application of the erase pulse can be lessened. Furthermore, a decrease in the number of times the erase pulse is applied can suppress degradation of the memory cell transistors MT, thereby leading to an improvement in the write/erase endurance.

Furthermore, in the configuration according to the present embodiment, the write/erase endurance can be improved with almost no decrease in the processing capability with respect to the erasing operation and a subsequent writing operation. Hereinafter, this effect will be specifically described.

Generally, the number of erase loops can be decreased by increasing the amount of the erase pulse stepped up. In addition, decreasing the number of times the erase pulse is applied suppresses degradation of the memory cell transistors MT, and thus, the write/erase endurance can be improved.

However, increasing the step-up amount causes a threshold voltage distribution of the memory cell transistors MT to be likely to spread after the erasing operation. Thus, the number of writes (number of program loops) significantly varies in the subsequent writing operation, and the number of writes tends to increase. Furthermore, the memory cell transistors MT tend to be degraded if the number of writes increases. Accordingly, while increasing the amount of the erase pulse stepped up decreases the erasing time and suppresses degradation of the memory cell transistors MT in the erasing operation, writing time increases in the subsequent writing operation, and the memory cell transistors MT tend to be degraded. Thus, generally in products, the amount of the erase pulse stepped up is set to the extent not resulting in these problems.

Regarding this point, in the configuration according to the present embodiment, the controller 200 can select the slow erase mode if, for example, the threshold voltage distribution varying after the erasing operation does not pose a problem in the subsequent writing operation or if suppressing degradation of the memory cell transistors MT is prioritized in the erasing operation. Alternatively, the controller 200 can select the normal erase mode if suppressing variation of the threshold voltage distribution after the erasing operation is prioritized or if the erasing time and the writing time of the subsequent writing operation, that is, the processing capability, are prioritized. Accordingly, in the configuration according to the present embodiment, the write/erase endurance can be improved with almost no decrease in the processing capability with respect to the erasing operation and the subsequent writing operation.

### 3. Third Embodiment

Next, a semiconductor memory device and a memory system according to a third embodiment will be described. The present embodiment results from applying the principle of the two erase modes described in the first embodiment to the writing operation. Hereinafter, only different points from the first and second embodiments will be described.

### 3. 1 Writing operation

First, a writing operation according to the present embodiment will be described. A writing operation includes an operation that applies a program pulse to increase (shift in a positive voltage direction) the threshold voltage of the memory cell transistor and includes program verification that determines whether or not the threshold voltage of the memory cell transistor MT, as a result of the application of the program pulse, reaches a target value. There are two program modes referred to as "normal program mode" and "slow program mode" in the writing operation. The NAND flash memory 100 performs the writing operation in any one program mode based on a command received from the controller 200. The normal program mode and the slow program mode have different conditions for the program pulse. Specifically, the level and time of voltage application to the selected word line WL are different in these modes. The potential of the program pulse is smaller in the slow program mode than is in the normal program mode, and the period of application of the program pulse is longer in the slow program mode than is in the normal program mode. Hereinafter, details of the writing operation will be described.

### 3. 1. 1 Operation of Controller 200

First, operation of the controller 200 during the writing operation will be described.

### 3. 1. 1. 1 In Normal Program Mode

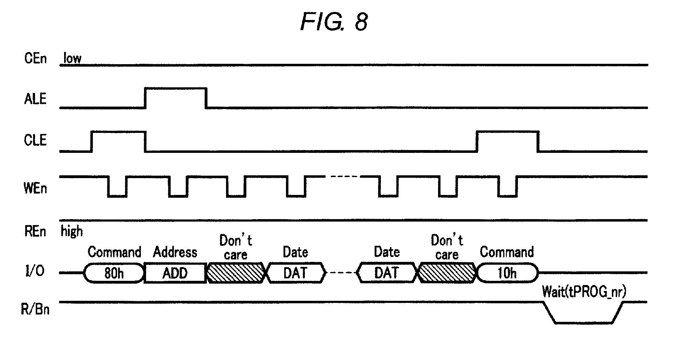

First, operation of the controller 200 in the normal program mode will be described with reference to FIG. 8.

As illustrated in FIG. 8, the processor 230, first, outputs a command "80h" to the NAND flash memory 100 and asserts the command latch enable signal CLE. The command "80h" notifies the NAND flash memory 100 to perform the writing operation.

Next, the processor 230 outputs the address data "ADD" and asserts the address latch enable signal ALE. While the address data has one cycle in the example of FIG. 8, the address data may have multiple cycles to transmit a column address, a row address, and the like.

Next, the processor 230 outputs write data "DAT" a necessary number of times in cycles.

The processor 230 outputs a normal program command "10h" and asserts the command latch enable signal CLE.

These commands, addresses, and data, for example, are stored in the register 123 of the NAND flash memory 100.

The NAND flash memory 100, in response to the command "10h", initiates the writing operation in the normal program mode and transitions into the busy state (R/Bn = "L"). Hereinafter, the period of the writing operation of the NAND flash memory 100 in the normal program mode, that is, the period of the busy state, will be designated by a reference sign tPROG_nr.

The NAND flash memory 100 transitions into the ready state when the writing operation is completed, and the ready/busy signal R/Bn returns to the "H" level.

### 3. 1. 1. 2 In Slow Program Mode

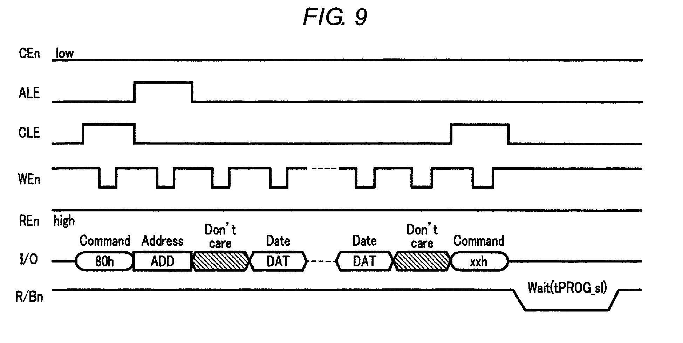

Next, operation of the controller 200 in the slow program mode will be described with reference to FIG. 9. Hereinafter, only different points from the normal program mode will be described.

As illustrated in FIG. 9, the processor 230, after outputting the write data, outputs a slow program command "xxh" and asserts the command latch enable signal CLE. Then, the NAND flash memory 100, in response to the command "xxh", initiates the writing operation in the slow program mode and transitions into the busy state (R/Bn = "L"). If the period of the busy state at this time is tPROG_sl, a relationship tPROG_sl > tPROG_nr is satisfied if the number of program loops is the same in both modes.

### 3. 1. 2 Operation of NAND Flash Memory 100

Next, operation of the NAND flash memory 100 during the writing operation will be described.

### 3. 1. 2. 1 Overall Flow of Writing operation

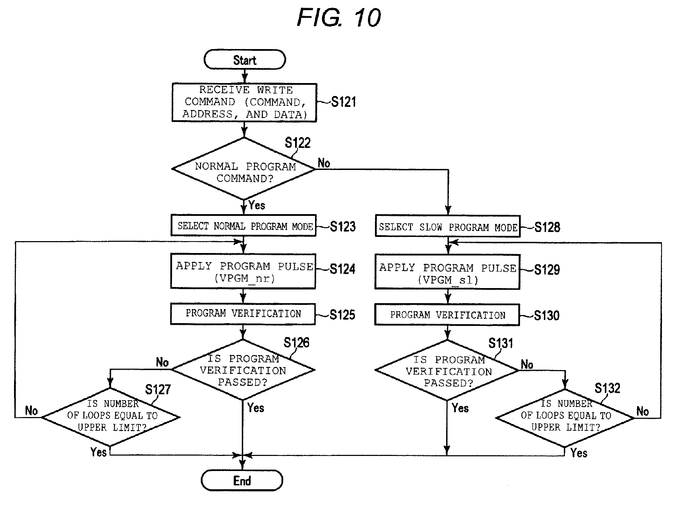

First, an overall flow of the writing operation will be described with reference to FIG. 10.

As illustrated in FIG. 10, first, the sequencer 121 receives a write command (command, address, and data) from the controller 200 (Step S121).

The sequencer 121 selects the normal program mode (Step S123) if the sequencer 121 receives the normal program command "10h" from the controller 200 (Yes in Step S122).

The sequencer 121 initiates the writing operation in response to the received command "10h" and, first, applies the program pulse. More specifically, the row decoder 112 applies the program pulse to the word lines WL in response to a command of the sequencer 121 (Step S124).

Next, the sequencer 121 performs the program verification (Step S125).

The writing operation ends if the program verification is passed (Yes in Step S126). Alternatively, if the program verification is failed (No in Step S126), the sequencer 121 determines whether or not the number of program loops is equal to a preset upper limit number (Step S127). Hereinafter, a repetition of application of the program pulse and the program verification will be referred to as "program loop". The sequencer 121 repeats application of the program pulse and the program verification until either the program verification is passed or the number of program loops reaches the upper limit number.

The sequencer 121, if the number of program loops reaches the upper limit number (Yes in Step S127), ends the writing operation and reports to the controller 200 that the writing operation is not normally ended.

The sequencer 121, if the number of program loops does not reach the upper limit number (No in Step S127), returns to Step S124 and again applies the program pulse.

The sequencer 121 selects the slow program mode (Step S128) if the sequencer 121 receives the slow program command "xxh" from the controller 200 (No in Step S122).

The sequencer 121 applies the program pulse in response to the command "xxh" (Step S129).

Next, the sequencer 121, in the same manner as in the normal program mode, performs the program verification (Step S130) and repeats the program loop until either the program verification is passed (Yes in Step S131) or the number of program loops reaches the preset upper limit number (Yes in Step S132).

### 3. 1. 2. 2 Voltage in Programming

Next, a relationship in potential between each wiring in programming will be described.

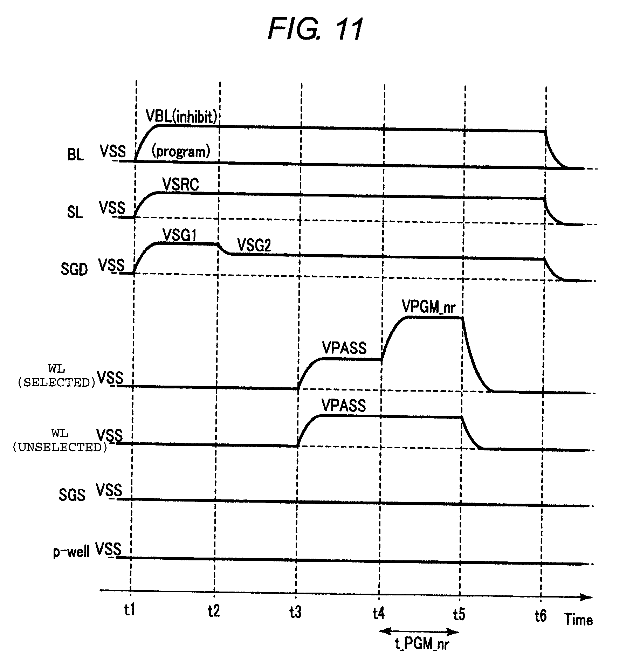

First, the relationship in the normal program mode will be described with reference to FIG. 11. As illustrated in FIG. 11, the sense amplifier 113, for example, applies a voltage VSS to the writing target (that changes the threshold voltage level of the target memory cell transistor MT) bit line BL (refer to a reference sign "program" in FIG. 11) and applies a voltage VBL (> VSS) to the non-writing target (that causes almost no change in the threshold voltage level of the target memory cell transistor MT) bit lines BL (refer to a reference sign "inhibit" in FIG. 11) at the time t1. The source line driver 114 applies a voltage VSRC (> VSS) to the source line SL. In this state, the row decoder 112 applies a voltage VSG1 to the select gate line SGD and brings the select transistor ST1 into an ON state. The voltage VSG1 brings the select transistor ST1 connected to the writing target bit line BL and the select transistors ST1 connected to the non-writing target bit lines BL together into the ON state. The voltage VSG1 satisfies a relationship VSG1 - Vt > VBL when a threshold voltage of the select transistor ST1 is Vt. In addition, the row decoder 112 applies the voltage VSS to the select gate line SGS and brings all of the select transistors ST2 into a cut-off state.

Next, the row decoder 112 applies a voltage VSG2 to the select gate line SGD of the selected block BLK at the time t2. The voltage VSG2 brings the select transistor ST1 connected to the writing target bit line BL into the ON state and brings the select transistors ST1 connected to the non-writing target bit lines BL into a cut-off state. Accordingly, the voltage VSG2 satisfies a relationship VSS < VSG2 - Vt < VBL. As a result, the voltage VSS is applied to a channel of the writing target memory cell transistor MT from the bit line BL, and channels of the non-writing target memory cell transistors MT fall into the floating state.

Next, the row decoder 112 applies a voltage VPASS to the selected word line WL and to the non-selected word lines WL at the time t3. The voltage VPASS prevents erroneous writing from being performed on the non-selected memory cell transistors MT while maintaining the ON state of the memory cell transistors MT regardless of the threshold voltages of the memory cell transistors MT.

Next, the row decoder 112 applies a voltage VPGM_nr, as the program pulse, to the selected word line WL at a time t4. The voltage VPGM_nr and the voltage VPASS satisfy a relationship VPGM_nr > VPASS. Accordingly, charges are injected into the charge storage layer of the writing target memory cell transistor MT connected to the selected word line WL according to the potential difference between the voltage VPGM_nr and the voltage VSS (channel potential). Alternatively, charges are not injected into the charge storage layers of the non-writing target memory cell transistors MT connected to the selected word line WL because the channel potential is increased by capacitive coupling with the voltage VPGM_nr.

Then, recovery is performed at times t5 and t6, and each wiring is reset. Hereinafter, the period during which the program pulse is applied once (during the times t4 and t5) in the normal program mode will be referred to as "period t_PGM_nr".

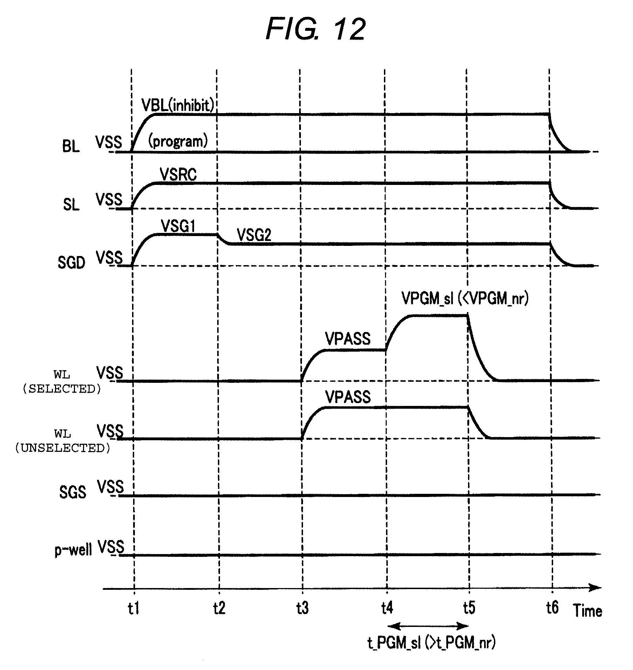

Next, the relationship in the slow program mode will be described with reference to FIG. 12. Hereinafter, only different points from the normal program mode will be described.

As illustrated in FIG. 12, the row decoder 112 applies a voltage VPGM_sl to the selected word line WL during the times t4 and t5. The voltage VPGM_sl, the voltage VPGM_nr, and the voltage VPASS satisfy a relationship VPGM_nr > VPGM_sl > VPASS (> VSS). Accordingly, the potential difference between the word lines WL and the back gates (p-well region) during application of the program pulse is smaller in the slow program mode than is in the normal program mode. Accordingly, charges are injected into the charge storage layer of the writing target memory cell transistor MT connected to the selected word line WL according to the potential difference between the voltage VPGM_sl and the voltage VSS (channel potential). Hereinafter, the period during which the program pulse is applied once (during the times t4 and t5) in the slow program mode will be referred to as "period t_PGM_sl", in which case a relationship t_PGM_sl > t_PGM_nr is satisfied. That is, the program pulse is set to have a smaller potential and to be applied for a longer period in the slow program mode than is in the normal program mode.

### 3. 3 Effect of Present Embodiment

The configuration according to the present embodiment can improve the write/erase endurance as in the first and second embodiments. Hereinafter, a specific description will be provided.

The write/erase endurance, for example, can be improved by decreasing the voltage of the program pulse (VPGM) during the writing operation as in decreasing the voltage of the erase pulse (VERA) during the erasing operation. However, in order to increase the threshold sufficiently, the period of application of the program pulse is required to be increased by an amount corresponding to the amount of the program pulse decreased. If the period of application of the program pulse increases, writing time (processing time from initiation of the writing operation until completion thereof) tends to increase, and in turn, the processing capability of the semiconductor memory device may be decreased. Therefore, generally in products, a complication exists in extending the period of application of the program pulse.

Regarding this point, in the configuration according to the present embodiment, the semiconductor memory device has two program modes of the normal program mode and the slow program mode. In addition, the controller 200, for example, can select either the normal program mode or the slow program mode according to whether or not the writing time is constrained. More specifically, the controller 200 selects the slow program mode if the writing time is not constrained, for example, if a subsequent command is not received yet from the host device. Accordingly, the semiconductor memory device decreases the voltage of the program pulse applied to the memory cell transistors MT and, thus, can suppress degradation of the memory cell transistors MT. That is, the semiconductor memory device can perform the writing operation by giving priority to improvement in the write/erase endurance.

Alternatively, the controller 200 selects the normal program mode if the writing time is constrained. Accordingly, the semiconductor memory device can perform the writing operation by giving priority to the writing time (processing capability).

Accordingly, in the configuration according to the present embodiment, selecting a program mode depending on the situation suppresses degradation of the memory cell transistors MT with almost no decrease in processing capability, thereby leading to an improvement in the write/erase endurance. In addition, an improvement in the write/erase endurance can increase the upper limit of the number of data rewrites.

Furthermore, the capability to suppress degradation of the memory cell transistors MT can suppress erroneous writing/erasing, thereby improving reliability.

In addition, in the configuration according to the present embodiment, since the potential of the program pulse is smaller in the slow program mode, the charging capacity of the word lines WL is reduced in comparison with the normal program mode. Accordingly, power consumption can be reduced.

### 4. Fourth Embodiment

Next, a semiconductor memory device and a memory system according to a fourth embodiment will be described. The present embodiment relates to a step-up amount in the writing operation of the third embodiment when stepping the program pulse up according to the number of program loops. Hereinafter, only different points from the third embodiment will be described.

### 4. 1 Relationship between Number of Program Loops and Program Pulse

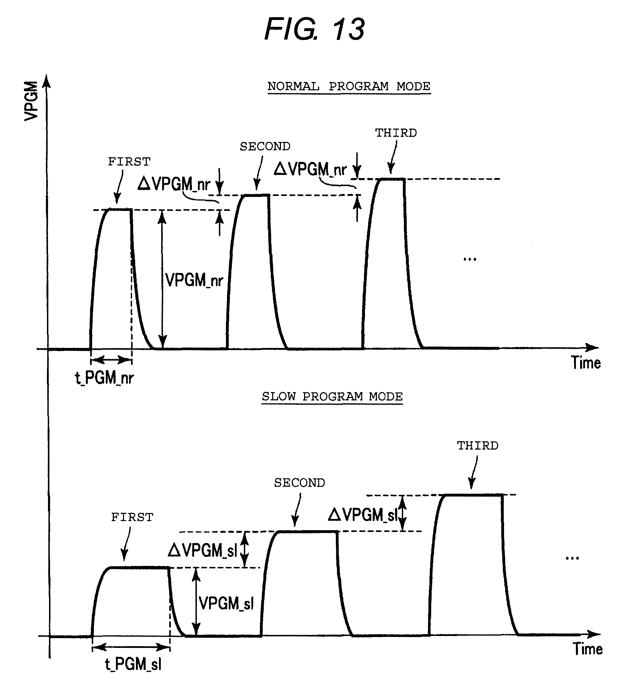

A relationship between the number of program loops and the program pulse (voltage VPGM) will be described with reference to FIG. 13. The upper portion of FIG. 13 illustrates a relationship between the number of program loops and the voltage VPGM_nr in the normal program mode, and the lower portion of FIG. 13 illustrates a relationship between the number of program loops and the voltage VPGM_sl in the slow program mode.

As illustrated at the upper portion of FIG. 13, the potential of the program pulse is stepped up by ΔVPGM_nr in the normal program mode each time the program loop is repeated. In contrast, as illustrated at the lower portion of FIG. 13, the potential of the program pulse is stepped up in the slow program mode by ΔVPGM_sl that is greater than ΔVPGM_nr in the normal program mode.

### 4. 2 Effect of Present Embodiment

In the configuration according to the present embodiment, the amount of the program pulse stepped up is greater in the slow program mode than is in the normal program mode. Accordingly, when the slow program mode is selected, the number of program loops (number of times the program pulse is applied) can be decreased while increasing a change in the threshold voltage resulting from one program pulse. Accordingly, a delay in the writing time resulting from an increased period of application of the program pulse can be prevented. Furthermore, a decrease in the number of times the program pulse is applied can improve the write/erase endurance.

Furthermore, in the configuration according to the present embodiment, the write/erase endurance can be improved more effectively with almost no decrease in the reliability of the write data. Hereinafter, this effect will be described.

Generally, the number of program loops can be decreased by increasing the amount of the program pulse stepped up. In addition, decreasing the number of times the program pulse is applied suppresses degradation of the memory cell transistors MT, and thus, the write/erase endurance can be improved. However, increasing the step-up amount causes a threshold voltage distribution of the memory cell transistors MT to be likely to spread and, thus, increases the possibility of erroneous writing or erroneous reading, thereby decreasing the reliability of data.

Regarding this point, in the configuration according to the present embodiment, the controller 200, for example, can select the slow program mode if variation of the threshold voltage distribution is less constrained, that is, if the variation has little effect on the reliability of data, or can select the normal program mode if suppressing variation of the threshold voltage distribution is prioritized, that is, if the reliability of the write data is prioritized. Accordingly, in the configuration according to the present embodiment, the write/erase endurance can be improved with almost no decrease in the reliability of the write data.

### 5. Fifth Embodiment

Next, a semiconductor memory device and a memory system according to a fifth embodiment will be described. The present embodiment relates to a specific example of selecting the slow erase mode in the first and second embodiments.

That is, in the present example, the slow erase mode is applied when the erasing operation is temporarily suspended by the controller 200 (hereinafter, referred to as "erasure suspension") and is resumed after another operation such as a reading operation is preferentially performed. While the present embodiment is described as preferentially performing a reading operation after the erasure suspension, for example, the writing operation or any other operation may be preferentially performed instead. Hereinafter, only different points from the first and second embodiments will be described.

One example of the erasure suspension is disclosed in U.S. Patent Application No. 13/052,158, entitled "NONVOLATILE SEMICONDUCTOR MEMORY DEVICE WHICH PERFORMS IMPROVED ERASING OPERATION," filed March 21, 2011. The entire content of this patent application is incorporated in the present specification by reference.

### 5. 1 First Example

First, a first example of the present embodiment will be described. The present example includes initiating the erasing operation in the normal erase mode and, after the erasing operation is suspended, resuming the erasing operation in the slow erase mode.

### 5. 1. 1 Overall Flow of Erasure Suspension

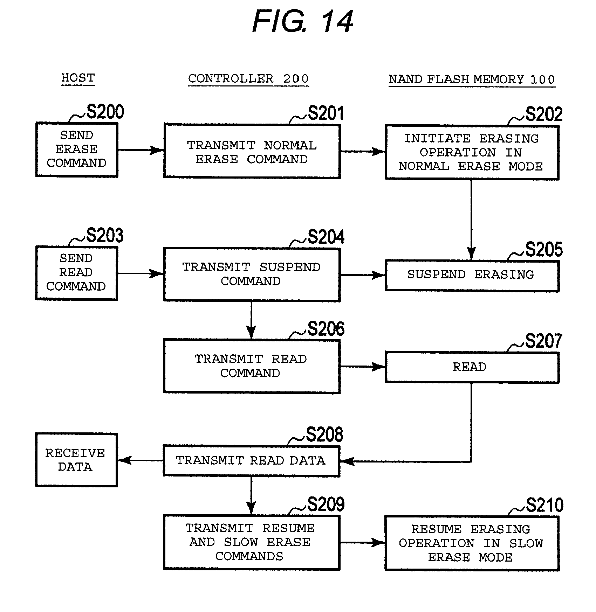

First, an overall flow of the erasure suspension will be described with reference to FIG. 14.

As illustrated in FIG. 14, first, the host interface circuit 210 of the controller 200 receives an erase command from the host device (Step S200).

The processor 230 of the controller 200, in response to the erase command, transmits a normal erase command and address data to the NAND flash memory 100 through the NAND interface circuit 250 (Step S201).

Then, the sequencer 121 of the NAND flash memory 100 performs the erasing operation in the normal erase mode based on the normal erase command received from the controller 200 (Step S202).

The controller 200, for example, is assumed to receive a read command from the host device while the NAND flash memory 100 performs the erasing operation (Step S203). Then, the processor 230 transmits a suspend command to the NAND flash memory 100 if the received reading operation is determined to be given priority over the erasing operation being currently performed (Step S204).

Then, the sequencer 121 temporarily suspends the erasing operation based on the received suspend command (Step S205). More specifically, the sequencer 121 suspends the erasing operation when application of the erase pulse or the erase verification performed at the time of reception of the suspend command is completed and, for example, stores status information at the time of suspension in the register 123. The sequencer 121 may also transmit the status information to the controller 200.

Next, the processor 230 transmits a read command and address data to the NAND flash memory 100 if confirmed that the erasing operation is suspended and that the ready/busy signal R/Bn returns to the "H" level (Step S206).

Then, the sequencer 121 reads data from the memory cell array based on the received read command (Step S207) and transmits the result of reading to the controller 200.

Next, the processor 230 transmits data to the host device after performing ECC and the like on the read data (Step S208) . Accordingly, after the reading operation is completed, the processor 230 transmits a resume command and a slow erase command with address data to the NAND flash memory 100 (Step S209).

Then, the sequencer 121 resumes the erasing operation in the slow erase mode based on the resume command and the slow erase command received (Step S210). More specifically, the sequencer 121 checks the status information in the register 123 and, if the erasing operation is suspended immediately after application of the erase pulse, resumes the erasing operation from the erase verification. Alternatively, if the erasing operation is suspended immediately after completion of the erase verification, the erasing operation is resumed from application of the erase pulse.

### 5. 1. 2 Erasing operation during Erasure Suspension

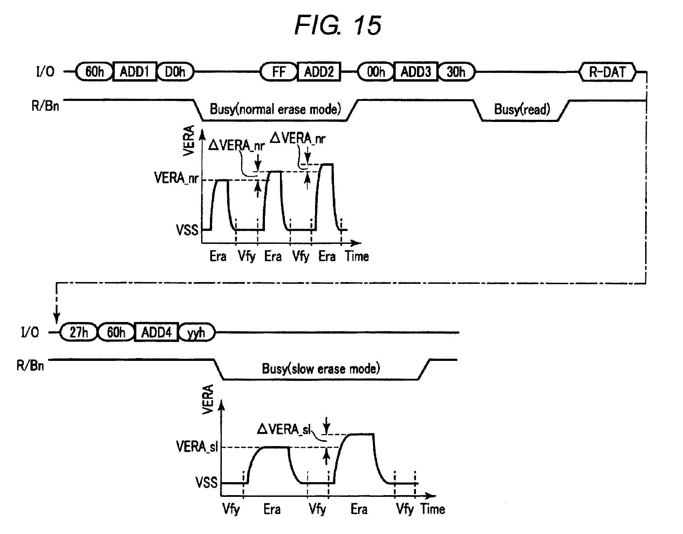

Next, the erasure suspension will be described in detail with reference to FIG. 15.

First, the processor 230, as illustrated in FIG. 3, outputs the command "60h" , address data "ADD1", and the normal erase command "D0h" as illustrated in FIG. 15 to perform the erasing operation in the normal erase mode. Then, the sequencer 121, in response to the command "D0h", initiates the erasing operation in the normal erase mode and transitions into the busy state (R/Bn = "L").

The processor 230, in the busy state, outputs a suspend command "FF" and address data "ADD2" when receiving a read command from the host device. The sequencer 121, when receiving the command "FF" in the busy state, ignores the address data "ADD2" and suspends the erasing operation. The command "FF" may suspend the erasing operation or may suspend all operations including writing, reading, and erasing in the NAND flash memory 100. In addition, the controller 200 may output the suspend command "FF" first or may output the address data "ADD2" first. The order of output is not particularly limited. Furthermore, the address data "ADD2" may not be output. In addition, while the sequencer 121 suspends a subsequent erasing operation (either application of the erase pulse or the erase verification) after receiving address data, the sequencer 121 may suspend the subsequent erasing operation after receiving the suspend command "FF", without waiting for the reception of the address data being completed.

The sequencer 121 receives the command "FF" and the address data "ADD2" before the end of application of the third erase pulse in the example of FIG. 15. Then, the sequencer 121 suspends the erasing operation after the end of the application of the third erase pulse and causes the ready/busy signal R/Bn to return to the "H" level.

Next, the processor 230 outputs a command "00h", address data "ADD3", and a read command "30h" after confirming that the ready/busy signal R/Bn returns to the "H" level. The command "00h" notifies the sequencer 121 to perform reading. While the address data is transferred in one cycle in the example of FIG. 15, the address data may be transferred in multiple cycles.

Next, the sequencer 121 initiates the reading operation in response to the command "30h" and transitions into the busy state. Then, the ready/busy signal R/Bn returns to the "H" level (ready state) when data "R-DAT" is completely read from the memory cell array 111. When the ready/busy signal R/Bn returns to the "H" level, the controller 200 transmits the read enable signal REn to the NAND flash memory 100 and reads the data "R-DAT".

Next, the processor 230 outputs a resume command "27h", the command "60h", address data "ADD4", and the slow erase command "yyh" when the reading operation is completed. Then, the sequencer 121, in response to the commands "27h" and "yyh", resumes the erasing operation in the slow erase mode after checking the status at the time of suspension of erasure and transitions into the busy state. Since the erasing operation is suspended immediately after application of the erase pulse in the example of FIG. 15, the erasing operation is resumed from the erase verification.

The ready/busy signal R/Bn returns to the "H" level when the erasing operation is completed in the NAND flash memory 100.

### 5. 2 Second Example

Next, a second example of the present embodiment will be described. The present example includes initiating the erasing operation in the slow erase mode in the first example. Hereinafter, only different points from the first example will be described.

### 5. 2. 1 Overall Flow of Erasure Suspension

First, an overall flow of the erasure suspension will be described.

Different points from FIG. 14 described in the first example are that the processor 230 outputs a slow erase command in Step S201 and that the sequencer 121 performs the erasing operation in the slow erase mode in Step S202.

### 5. 2. 2 Erasing operation during Erasure Suspension

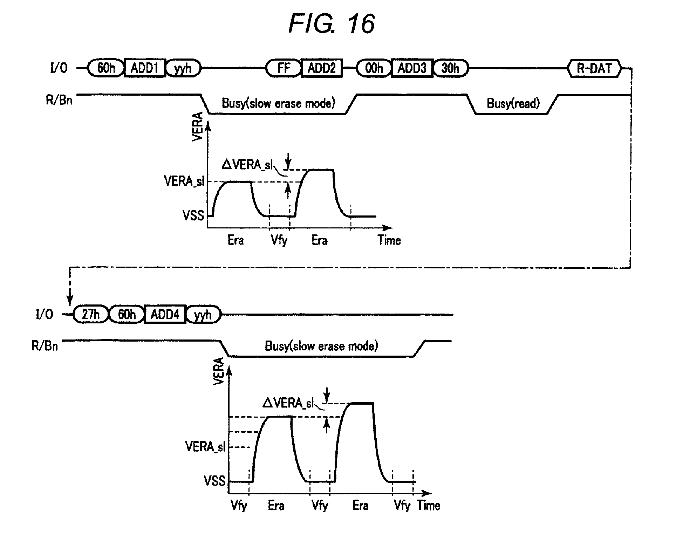

Next, the erasure suspension will be described in detail with reference to FIG. 16.

As illustrated in FIG. 16, the processor 230, first, outputs the command "60h", the address data "ADD1", and the slow erase command "yyh" to perform the erasing operation in the slow erase mode. Then, the sequencer 121, in response to the command "yyh", initiates the erasing operation in the slow erase mode and transitions into the busy state (R/Bn = "L").

The processor 230 outputs the suspend command "FF" and the address data "ADD2" when the controller 200 receives a read command from the host device while the NAND flash memory 100 is in the busy state. The sequencer 121 of the NAND flash memory 100 suspends the erasing operation in response to the command "FF". The sequencer 121 receives the command "FF" and the address data "ADD2" before the end of application of the second erase pulse in the example of FIG. 16 and, thus, suspends the erasing operation after the end of the application of the second erase pulse.

Then, the sequencer 121 performs the reading operation in response to a command of the controller 200. When the reading operation is completed, the controller 200 transmits the resume command "27h", the command "60h", the address data "ADD4", and the slow erase command "yyh" to the NAND flash memory 100. The sequencer 121, in response to these signals, resumes the erasing operation in the slow erase mode after checking the status information at the time of suspension of erasure stored in the register 123. Since the erasing operation is suspended after the application of the second erase pulse in the example of FIG. 16, the sequencer 121 resumes the erasing operation from the erase verification. The erase mode does not change before and after the erasure suspension in the present example. Therefore, the sequencer 121, when applying a subsequent erase pulse (third erase pulse), steps the erase pulse up in the same condition as the third erase loop (VERA_sl + 2 x ΔVERA_sl).

The potential of the first erase pulse after resumption is set as an initial value if the erase mode is changed as described in the first example.

### 5. 3 Effect of Present Embodiment

In the configuration according to the present embodiment, suspending erasing allows another operation to be interposed during the erasing operation. For example, the controller 200, when receiving a command from the host device to read a block BLK different from the block BLK in which the erasing operation is being performed, can interpose the reading operation even if the erasing operation is not completed. Accordingly, a command from the host device can be preferentially processed, and the slow erase mode can be selected after the erasing time becomes unconstrained.

Furthermore, the erasing operation can resume after being suspended by the erasure suspension in the configuration according to the present embodiment. That is, even if the erasing time is constrained in order to perform a subsequent different operation, for example, an operation of reading a block BLK different from the erasure target block BLK, the erasing operation being not completed within the constrained time does not pose a problem. Accordingly, the slow erase mode can be applied even in such a case. Accordingly, the scope of application of the slow erase mode can be increased, and the write/erase endurance can be further improved.

While the erasing operation is described as being suspended once by the erasure suspension in the present embodiment, the erasing operation may be suspended multiple number of times.

Furthermore, the slow erase mode may be selected at the time of initiation of the erasing operation, and the normal erase mode may be selected after the erasure suspension.

### 6. Sixth Embodiment

Next, a semiconductor memory device and a memory system according to a sixth embodiment will be described. The present embodiment relates to a specific example of selecting the slow program mode in the third and fourth embodiments.

That is, in the present example, if data having a smaller size than a page is written into a page, dummy data is written into an empty area of the page, and the slow program mode is applied in writing the dummy data. Hereinafter, only different points from the third and fourth embodiments will be described.

### 6. 1 Overall Flow of Dummy Data Writing

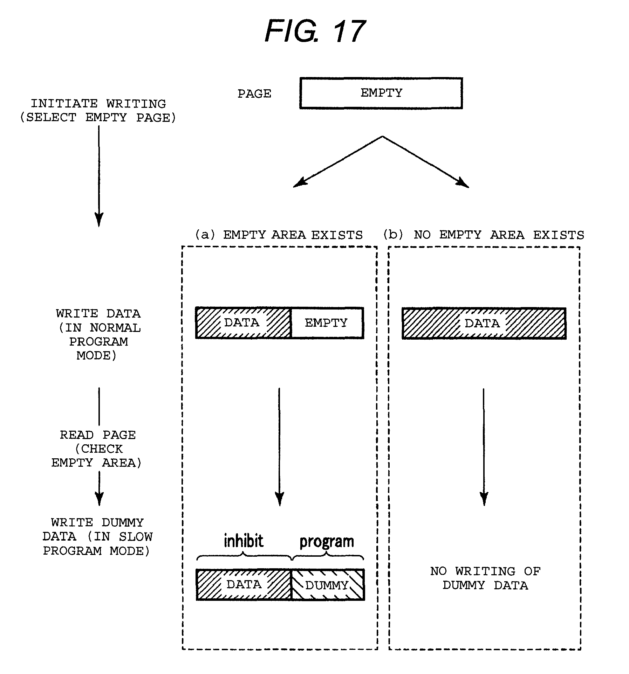

First, an overall flow of dummy data writing will be described with reference to FIG. 17 with particular focus on a relationship with an empty area of a page.

As illustrated in FIG. 17, first, the sequencer 121, at the time of initiating the writing operation, selects a page where data is not written when receiving a normal program command from the processor 230 of the controller 200.

Next, the sequencer 121 writes data into the selected page in the normal program mode in response to the normal program command received from the processor 230. At this time, if the size of data received from the processor 230 is smaller than the size of the page, there exists an area where data is not written (hereinafter, referred to as "empty area") in the selected page (part (a) of FIG. 17). Alternatively, if the size of the data is the same as the size of the page, there exists no empty area in the selected page (part (b) of FIG. 17).

Next, the processor 230 reads the written data from the NAND flash memory 100 when the writing operation ends. Then, the processor 230 checks if there exists an empty area by comparing the write data with the data of the page read.

The processor 230, if there exists an empty area, commands the sequencer 121 to write the dummy data into the empty area in the slow program mode. More specifically, the processor 230 transmits a column address specifying the empty area and the dummy data to the NAND flash memory 100. In addition, the processor 230 stores information about the dummy data being written into the empty area and prevents the empty area where the dummy data is written from being selected in subsequent data writing.

Then, the sequencer 121 writes the dummy data into the empty area in the slow program mode based on the command and the address received. The dummy data is preferably not erasure level (E level) data. More specifically, for example, if the memory cell transistors MT can store two-bit (four-value) data and threshold voltage levels that correspond to the four values include, from smallest to greatest, an E level, an A level, a B level, and a C level, the dummy data is preferably not the E level and may be any one of the A level, the B level, and the C level or may be an intermediate level between these levels.

Data is written in the size of the page. Accordingly, when writing the dummy data, the dummy data is required not to be written into the memory cell transistor MT where the previously written real data is written. Therefore, if "0" data indicates a writing target and that "1" data indicates a non-writing target, the "1" data is provided to the bit line BL that corresponds to the memory cell transistor MT where the real data is written. In addition, the bit line that corresponds to the memory cell transistor into which the dummy data is to be written is provided with either the "1" data or the "0" data corresponding to the A level to the C level.

Alternatively, the processor 230 does not write the dummy data if there exists no empty area.

While data is described as being written into one page in the present embodiment, data may be written into two or more pages depending on the size of data. In this case, reading only the data of the last page may be sufficient, or obviously, the data of all pages may be read. Furthermore, while a page reading operation and a dummy data writing operation are performed continuously after completion of the writing operation in the present embodiment, each operation may not be performed continuously. For example, the controller 200, when receiving a command for another processing from the host device, may preferentially perform the processing and then perform the page reading operation and the dummy data writing operation.

### 6. 2 Dummy Data Writing operation

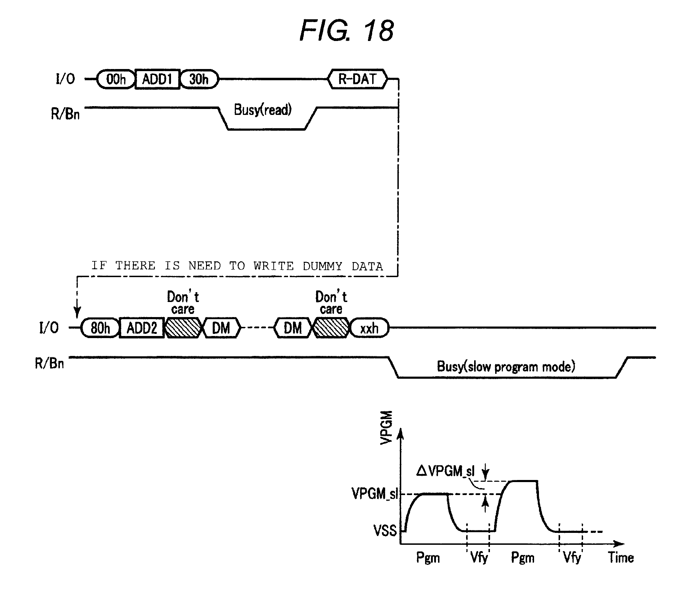

Next, the dummy data writing operation will be described with reference to FIG. 18. The writing operation performed in the normal program mode in FIG. 17 is the same as in FIG. 13. Therefore, the example of FIG. 18 illustrates the reading operation and the dummy data writing operation.

As illustrated in FIG. 18, the processor 230 outputs the command "00h", which notifies the sequencer 121 to perform reading, the address data "ADD1", and the read command "30h" in order to read the written data. The sequencer 121 initiates the reading operation in response to the command "30h" and transitions into the busy state (R/Bn = "L"). Then, the ready/busy signal R/Bn returns to the "H" level when the data "R-DAT" is completely read from the memory cell array 111. When the ready/busy signal R/Bn returns to the "H" level, the processor 230 transmits the read enable signal REn to the NAND flash memory 100 and reads the data "R-DAT".

Next, the processor 230 checks if there exists an empty area from the read data. If writing of the dummy data is determined to be required, the processor 230 outputs the command "80h" that notifies the sequencer 121 to write dummy data, the address data "ADD2" that specifies an empty area, dummy data "DM", and the slow program command "xxh". The sequencer 121 performs the dummy data writing operation in the slow program mode in response to the command "xxh".

### 6. 3 Effect of Present Embodiment

In the configuration according to the present embodiment, writing the dummy data into an empty area of a page in the slow program mode can suppress degradation of the memory cell transistors MT due to over-erasure, thereby leading to an improvement in the write/erase endurance. Hereinafter, this effect will be described.

In the data erasing operation, the erase pulse is applied to the memory cell transistor MT storing a bit corresponding to an empty area of a page, that is, the E level data, as well as the memory cell transistor MT storing other level data. Thus, the threshold voltage of the memory cell transistor MT corresponding to an empty area is significantly shifted to the minus side (negative voltage side) thereof (hereinafter, referred to as "over-erasure"). Then, the memory cell transistor MT is likely to be degraded by over-erasure. In addition, writing data into the memory cell transistor MT that resides in an over-erasure state requires a greater number of program loops than writing data into the memory cell transistor MT that has a threshold voltage close to 0V. Therefore, the memory cell transistors MT may be more likely to be degraded.

Regarding this point, the dummy data is written into an empty area of a page in the configuration according to the present embodiment. Accordingly, the memory cell transistor MT having an empty area can be prevented from falling into the over-erasure state during the erasing operation. Accordingly, degradation of the memory cell transistor MT having an empty area can be suppressed. Furthermore, writing the dummy data in the slow program mode can also suppress degradation of the memory cell transistors MT due to dummy data writing. Therefore, the write/erase endurance can be improved.

Furthermore, the dummy data may be any data except for the E level (any threshold voltage residing on the positive voltage side from the E level) in order to prevent over-erasure, and a threshold voltage distribution of the memory cell transistor MT where the dummy data is written may be greater than a threshold voltage distribution thereof in normal data writing. Thus, the number of program loops can be decreased by increasing the step-up amount of ΔVPGM_sl through application of the fourth embodiment.

The threshold voltage of the memory cell transistor MT where the dummy data is written is preferably a neutral threshold voltage. A neutral threshold voltage is a threshold voltage that almost does not change and resides in a stabilized state where charges of the charge storage layer are barely affected by leakage from the insulating film around the charge storage layer.

### 7. Seventh Embodiment

Next, a semiconductor memory device and a memory system according to a seventh embodiment will be described. The present embodiment includes determining the erase mode or the program mode in the first to fourth embodiments according to the number of data erases in the memory cell transistors MT. Hereinafter, only different points from the first to fourth embodiments will be described.

### 7. 1 Management Table for Number of Erases

First, a table of the number of erases in the present embodiment will be described. The controller 200, for example, includes a table of the number of erases in the internal memory 220. The table of the number of erases stores a number of erases m for each block BLK (or for each unit of erasure) and a determination value M (M is an arbitrary integer) for determination of an erase mode. The value of the number of erases m is updated each time erasing is performed in the target block BLK.

The table of the number of erases may be provided in a ROM fuse (not illustrated) of the NAND flash memory 100. In addition, for example, the controller 200 may read data of the ROM fuse from the NAND flash memory 100 when power is supplied.

### 7. 2 First Example: Selecting Erase Mode

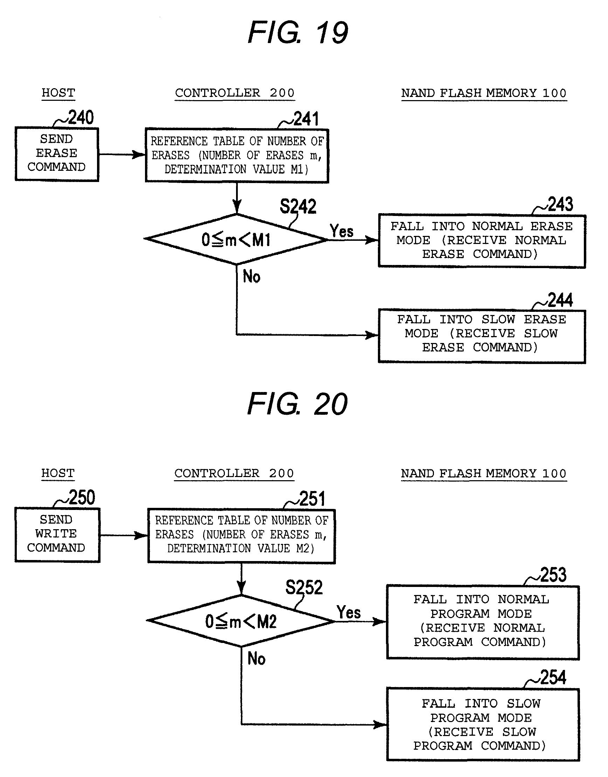

Next, selection of an erase mode by the controller 200 according to the number of erases m of the target block BLK will be described with reference to FIG. 19. A determination value in determining an erase mode will be set as a number M1 (M1 is an arbitrary integer) in the present example.

As illustrated in FIG. 19, first, the controller 200 receives an erase command from the host device (Step S240).

Next, the processor 230 of the controller 200 references the table of the number of erases and compares the number of erases m of the erasure target block BLK with the erase mode determination value M1 (Step S241).

The processor 230 outputs a normal erase command in a case of 0 ≤ number of erases m < M1 (Yes in Step S242). The NAND flash memory 100 performs the erasing operation in the normal erase mode in response to the normal erase command (Step S243).

Alternatively, the processor 230 outputs a slow erase command in a case of number of erases m ≥ M1 (No in Step S242). The NAND flash memory 100 performs the erasing operation in the slow erase mode in response to the slow erase command (Step S244).

The number of erases m is updated when the erasing operation is completed (for example, m = m + 1).

### 7. 3 Second Example: Selecting Program Mode

Next, selection of a program mode by the controller 200 according to the number of erases m of the target block BLK will be described with reference to FIG. 20. A determination value in determining a program mode will be set as a number M2 (M2 is an arbitrary integer) in the present example.

As illustrated in FIG. 20, first, the controller 200 receives a write command from the host device (Step S250).

Next, the processor 230 of the controller 200 references the table of the number of erases and compares the number of erases m of the writing target block BLK with the program mode determination value M2 (Step S251).

The processor 230 outputs a normal program command in a case of 0 ≤ number of erases m < M2 (Yes in Step S252). The NAND flash memory 100 performs the writing operation in the normal program mode in response to the normal program command (Step S253).

Alternatively, the processor 230 outputs a slow program command in a case of number of erases m ≥ M2 (No in Step S252). The NAND flash memory 100 performs the writing operation in the slow program mode in response to the slow program command (Step S254).

While a program mode is selected for each block according to the table of the number of erases in the present example, a program mode may be selected according to the number of writes for each page. In this case, the controller 200 may include a table of the number of writes and may manage the number of writes and a determination value for each page. The number of writes is updated each time the writing operation is performed.

### 7. 4 Effect of Present Embodiment

According to the present embodiment, variation of the reliability of data can be suppressed for each block BLK. Hereinafter, a specific description will be provided.

The memory cell transistors MT degrade as the number of data rewrites increases. Thus, as the number of rewrites is greater (frequency of use is higher) in the block BLK, degradation of the memory cell transistors MT progresses and leads to a change in erasing and writing characteristics. Therefore, the reliability of data may be decreased. Accordingly, the reliability of data may vary for each block BLK according to the different number of rewrites.

Regarding this point, the number of erases is managed for each block BLK in the configuration according to the present embodiment. In addition, the slow erase mode or the slow program mode is selected for the block BLK where the number of erases exceeds a determination value. Accordingly, for the block BLK where the number of rewrites is great, the writing operation or the erasing operation can be performed by prioritizing suppression of degradation. Accordingly, variation of the reliability of data according to the different number of rewrites can be suppressed.

### 8. Modification Examples

A semiconductor memory device (100 in FIG. 1) according to the above embodiments has a first operation mode (the normal erase mode or the normal program mode) and a second operation mode (the slow erase mode or the slow program mode) and includes a memory cell transistor (MT in FIG. 2) and a word line (WL in FIG. 2) connected to the memory cell transistor. An erase pulse (VERA_nr or VERA_sl in FIG. 6) is applied to the memory cell transistor when data of the memory cell transistor is erased. A program pulse (VPGM_nr in FIG. 11 or VPGM_sl in FIG. 12) is applied to the memory cell transistor when data is written into the memory cell transistor. In the first operation mode, application of the erase pulse or the program pulse during a first period (t_ERA_nr in FIG. 6 or t_PGM_nr in FIG. 11) generates a potential difference between a back gate of the memory cell transistor and the word line as a first potential difference (VERA_nr - VERA_WL or VPGM_nr - VSS). In the second operation mode, application of the erase pulse or the program pulse during a second period (t_ERA_sl in FIG. 6 or t_PGM_sl in FIG. 12) that is longer than the first period generates a potential difference between the back gate and the word line as a second potential difference (VERA_sl - VERA_WL or VPGM_sl - VSS) that is smaller than the first potential difference.

Application of the above embodiments can provide a semiconductor memory device and a memory system capable of suppressing degradation of a memory cell transistor.

The embodiments are not limited to the forms described above and may be modified in a various manner.

In the above embodiments, for example, the controller 200 may select the slow erase mode (or the slow program mode) according to a cycle of the number of erases. Specifically, for example, the controller 200 may be set to select the slow erase mode (or the slow program mode) once per three erasing operations. Furthermore, the number of times the controller 200 is set may be changed arbitrarily.

Furthermore, when data is written before shipment of products, the data may be written in the slow program mode by applying the above embodiments.

Furthermore, in the above embodiments, the controller 200 may apply the slow program mode when moving data between the blocks BLK in the memory cell array 111. Specifically, for example, when data of one block BLK is erased, valid data in the block BLK is required to be moved to another block BLK. At this time, the slow program mode may be applied in the writing operation.

Furthermore, either the erase mode or the program mode according to the embodiments may be applied, or both may be applied in the above embodiments. Furthermore, multiple embodiments may be combined. For example, both of the fifth embodiment and the sixth embodiment may be applied, or both of the first example and the second example of the seventh embodiment may be applied.

Furthermore, the sixth embodiment may not include the data reading operation by causing the controller 200 to determine the presence of an empty area of a page in advance from the size of the write data. In this case, the controller 200 may instruct the NAND flash memory 100 to write the dummy data without the reading operation. The NAND flash memory 100 is described in the sixth embodiment as writing the dummy data by a command of the controller 200. However, if the NAND flash memory 100 can recognize that data received from the controller 200 is smaller than the size of a page, the NAND flash memory 100 may internally generate the dummy data and write the dummy data into an empty area without waiting for a command from the controller 200. In addition, the slow program mode can be applied in the writing operation. In this case, the controller 200 may be notified by the NAND flash memory 100 of information indicating that the dummy data is written in the empty area or may determine that the dummy data is written in the empty area at the point in time when data smaller than the size of a page is transmitted to the NAND flash memory 100.

Furthermore, the above embodiments can be applied to a three-dimensional stacked NAND flash memory in which the memory cell transistors MT are stacked on a semiconductor substrate.

Furthermore, the word "connect" used in the above embodiments also includes a state where two things are indirectly connected while another thing such as a transistor or a resistor is interposed therebetween.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

Each exemplary embodiment described herein may be configured as follows. For example, if the memory cell transistors MT can store two-bit (four-value) data and that a threshold voltage level when the data stores one of the four values includes, from smallest to greatest, the E level (erasure level), the A level, the B level, and the C level, (1) in the reading operation, a voltage that is applied to the word line selected in the A level reading operation is in the range of, for example, from 0 V to 0.55 V. The voltage is not limited thereto and may be in any one range of from 0.1 V to 0.24 V, from 0.21 V to 0.31 V, from 0.31 V to 0.4 V, from 0.4 V to 0.5 V, and from 0.5 V to 0.55 V.

A voltage that is applied to the word line selected in the B level reading operation is in the range of, for example, from 1.5 V to 2.3 V. The voltage is not limited thereto and may be in any one range of from 1.65 V to 1.8 V, from 1.8 V to 1.95 V, from 1.95 V to 2.1 V, and from 2.1 V to 2.3 V.

A voltage that is applied to the word line selected in the C level reading operation is in the range of, for example from 3.0 V to 4.0 V. The voltage is not limited thereto and may be in any one range of from 3.0 V to 3.2 V, from 3.2 V to 3.4 V, from 3.4 V to 3.5 V, from 3.5 V to 3.6 V, and from 3.6 V to 4.0 V.

The time of the reading operation (tR) may be in the range of, for example, from 25 µs to 38 us, from 38 µs to 70 µs, or from 70 µs to 80 µs.

(2) The writing operation includes a programming operation and a verifying operation as described above. In the writing operation, a voltage that is initially applied to the word line selected in the programming operation is in the range of, for example, from 13.7 V to 14.3 V. The voltage is not limited thereto and may be in any one range of, for example, from 13.7 V to 14.0 V and from 14.0 V to 14.6 V.

A voltage that is initially applied to the selected word lines when writing is performed on the odd word lines may be interchanged with a voltage that is initially applied to the selected word lines when writing is performed on the even word lines.

The programming operation when performed by employing incremental step pulse programming (ISPP) has a step-up voltage of, for example, approximately 0.5 V.

A voltage that is applied to the non-selected word lines may be in the range of, for example, from 6.0 V to 7.3 V. The voltage is not limited thereto and, for example, may be in the range of from 7.3 V to 8.4 V or may be less than or equal to 6.0 V.

The pass voltage to be applied may be changed according to whether the non-selected word lines are the odd word lines or the even word lines.

The time of the writing operation (tProg) may be in the range of, for example, from 1,700 µs to 1,800 µs, from 1,800 µs to 1,900 µs, or from 1,900 µs to 2,000 µs.

(3) In the erasing operation, a voltage that is initially applied to a well that is formed on the semiconductor substrate and on which the memory cells are arranged is in the range of, for example, from 12 V to 13.6 V. The voltage is not limited thereto and, for example, may be in the range of from 13.6 V to 14.8 V, from 14.8 V to 19.0 V, from 19.0 V to 19.8 V, or from 19.8 V to 21 V.

The time of the erasing operation (tErase) may be in the range of, for example, from 3,000 µs to 4,000 µs, from 4,000 µs to 5,000 µs, or from 4,000 µs to 9,000 µs.

(4) A structure of each memory cell includes a charge storage layer that is arranged on the semiconductor substrate (silicon substrate) through a tunnel insulating film having a thickness between 4 nm and 10 nm. The charge storage layer can be configured as a stacked structure of an insulating film of SiN, SiON, or the like having a thickness between 2 nm and 3 nm and a polysilicon having a thickness between 3 nm and 8 nm. In addition, a metal such as Ru may be added to the polysilicon. The charge storage layer includes an insulating film thereon. This insulating film, for example, includes a silicon oxide film having a thickness between 4 nm and 10 nm that is interposed between a lower High-k film having a thickness between 3 nm and 10 nm and an upper High-k film having a thickness between 3 nm and 10 nm. The High-k films are made of, for example, HfO. The thickness of the silicon oxide film can be greater than the thickness of the High-k films. A control electrode having a thickness between 30 nm and 70 nm is formed on the insulating film through a material having a thickness between 3 nm and 10 nm. The material is a metal oxide film of TaO or the like or is a metal nitride film of TaN or the like. For example, W can be used in the control electrode.

In addition, an air gap can be formed between the memory cells.

## Claims

1. A semiconductor memory device comprising:
a memory cell transistor; and
a word line that is connected to a gate of the memory cell transistor,
wherein an erase voltage of a first level is applied to the memory cell transistor when an erasing operation of a first type is performed on the memory cell transistor, and an erase voltage of a second level, which is lower than the first level, is applied to the memory cell transistor when an erasing operation of a second type is performed on the memory cell transistor.

2. The semiconductor memory device according to claim 1, wherein the erase voltage of the first level is applied to the memory cell transistor for a first time period when the erasing operation of the first type is performed on the memory cell transistor, and the erase voltage of the second level is applied to the memory cell transistor for a second time period, which is longer than the first time period, when the erasing operation of the second type is performed on the memory cell transistor.

3. The semiconductor memory device according to claim 2, wherein the erasing operation of the first type is performed on the memory cell transistor in response to a first erase command, and the erasing operation of the second type is performed on the memory cell transistor in response to a second erase command which is different from the first erase command.

4. The semiconductor memory device according to claim 1, wherein
the erasing operation of the first type is repeated with an erase voltage of a third level, which is higher than the first level, if the erasing operation of the first type did not succeed, and the erasing operation of the second type is repeated with an erase voltage of a fourth level, which is higher than the second level, if the erasing operation of the second type did not succeed, and
a difference between the third level of the erase voltage and the first level of the erase voltage is less than a difference between the fourth level of the erase voltage and the second level of the erase voltage.

5. The semiconductor memory device according to claim 1, wherein the erasing operation of the first type is performed on the memory cell transistor if the number of prior erasing operations performed on the memory cell transistor is less than a threshold number and the erasing operation of the second type is performed on the memory cell transistor if the number of prior erasing operations performed on the memory cell transistor is greater than the threshold number.

6. The semiconductor memory device according to claim 1, wherein
wherein a programming voltage of a first level is applied to the memory cell transistor when a programming operation of a first type is performed on the memory cell transistor, and a programming voltage of a second level, which is lower than the first level, is applied to the memory cell transistor when a programming operation of a second type is performed on the memory cell transistor.

7. The semiconductor memory device according to claim 6, wherein the programming voltage of the first level is applied to the memory cell transistor for a third time period when the programming operation of the first type is performed on the memory cell transistor, and the programming voltage of the second level is applied to the memory cell transistor for a fourth time period, which is longer than the third time period, when the programming operation of the second type is performed on the memory cell transistor.

8. The semiconductor memory device according to claim 7, wherein the programming operation of the first type is performed on the memory cell transistor in response to a first write command, and the programming operation of the second type is performed on the memory cell transistor in response to a second write command which is different from the first write command.

9. The semiconductor memory device according to claim 6, wherein
the programming operation of the first type is repeated with a programming voltage of a third level, which is higher than the first level, if the programming operation of the first type did not succeed, and the programming operation of the second type is repeated with a programming voltage of a fourth level, which is higher than the second level, if the programming operation of the second type did not succeed, and
a difference between the third level of the programming voltage and the first level of the programming voltage is less than a difference between the fourth level of the programming voltage and the second level of the programming voltage.

10. The semiconductor memory device according to claim 1, wherein the programming operation of the first type is performed on the memory cell transistor if the number of erasing operations performed on the memory cell transistor is less than a threshold number and the programming operation of the second type is performed on the memory cell transistor if the number of erasing operations performed on the memory cell transistor is greater than the threshold number.

11. A memory system comprising:
a controller; and
a semiconductor memory device including a memory cell transistor and a word line connected to a gate of the memory cell transistor, wherein an erase voltage of a first level is applied to the memory cell transistor when an erasing operation of a first type is performed on the memory cell transistor, and an erase voltage of a second level, which is lower than the first level, is applied to the memory cell transistor when an erasing operation of a second type is performed on the memory cell transistor.

12. The memory system according to claim 11, wherein the erase voltage of the first level is applied to the memory cell transistor for a first time period when the erasing operation of the first type is performed on the memory cell transistor, and the erase voltage of the second level is applied to the memory cell transistor for a second time period, which is longer than the first time period, when the erasing operation of the second type is performed on the memory cell transistor.

13. The memory system according to claim 12, wherein the erasing operation of the first type is performed on the memory cell transistor in response to a first erase command which is issued by the controller, and the erasing operation of the second type is performed on the memory cell transistor in response to a second erase command which is issued by the controller and is different from the first erase command.

14. The memory system according to claim 11, wherein the erasing operation of the first type is repeated with an erase voltage of a third level, which is higher than the first level, if the erasing operation of the first type did not succeed, and the erasing operation of the second type is repeated with an erase voltage of a fourth level, which is higher than the second level, if the erasing operation of the second type did not succeed, and
a difference between the third level of the erase voltage and the first level of the erase voltage is less than a difference between the fourth level of the erase voltage and the second level of the erase voltage.

15. The memory system according to claim 11, wherein the erasing operation of the first type is performed on the memory cell transistor if the number of prior erasing operations performed on the memory cell transistor is less than a threshold number and the erasing operation of the second type is performed on the memory cell transistor if the number of prior erasing operations performed on the memory cell transistor is greater than the threshold number.

16. The memory system according to claim 11, wherein wherein a programming voltage of a first level is applied to the memory cell transistor when a programming operation of a first type is performed on the memory cell transistor, and a programming voltage of a second level, which is lower than the first level, is applied to the memory cell transistor when a programming operation of a second type is performed on the memory cell transistor.

17. The memory system according to claim 16, wherein the programming voltage of the first level is applied to the memory cell transistor for a third time period when the programming operation of the first type is performed on the memory cell transistor, and the programming voltage of the second level is applied to the memory cell transistor for a fourth time period, which is longer than the third time period, when the programming operation of the second type is performed on the memory cell transistor.

18. The memory system according to claim 17, wherein the programming operation of the first type is performed on the memory cell transistor in response to a first write command which is issued by the controller, and the programming operation of the second type is performed on the memory cell transistor in response to a second write command which is issued by the controller and is different from the first write command.

19. The memory system according to claim 16, wherein the programming operation of the first type is repeated with a programming voltage of a third level, which is higher than the first level, if the programming operation of the first type did not succeed, and the programming operation of the second type is repeated with a programming voltage of a fourth level, which is higher than the second level, if the programming operation of the second type did not succeed, and
a difference between the third level of the programming voltage and the first level of the programming voltage is less than a difference between the fourth level of the programming voltage and the second level of the programming voltage.

20. The memory system according to claim 11, wherein the programming operation of the first type is performed on the memory cell transistor if the number of erasing operations performed on the memory cell transistor is less than a threshold number and the programming operation of the second type is performed on the memory cell transistor if the number of erasing operations performed on the memory cell transistor is greater than the threshold number.
